# EUROPEAN PATENT SPECIFICATION

(11) **EP 0 914 025 B1**
(45) Date of publication and mention of the grant of the patent: **10.04.2002**
(21) Application number: 98203511.5
(22) Date of filing: 19.10.1998
(51) Int. Cl.: H05B 33/26, H05B 33/28

(54) **A multistructured electrode for use with electroluminescent devices**
Multistrukturierte Elektrode für elektrolumineszente Vorrichtungen
Electrode multistructurée pour dispositifs électroluminescents

(30) Priority: 30.10.1997 US 961433
(43) Date of publication of application: 06.05.1999
(73) Proprietor: EASTMAN KODAK COMPANY, Rochester, New York 14650 (US)
(72) Inventor: Hung, Liang Sun, Rochester, New York 14650-2201 (US); Zheng, Longru, Rochester, New York 14650-2201 (US); Mason, Max G., Rochester, New York 14650-2201 (US)
(74) Representative: Lewandowsky, Klaus, Dipl.-Ing.

(56) References cited:
- US-A- 5 491 377
- PATENT ABSTRACTS OF JAPAN vol. 097, no. 011, 28 November 1997 & JP 09 180882 A (NEC KANSAI LTD), 11 July 1997

## Description

This invention relates to a multilayer electrode which is particularly suitable for use in organic electroluminescent (EL) devices with efficient hole injection/transport and good operational stability.

Organic EL devices are known to be highly efficient and are capable of producing a wide range of colors. Useful applications such as flat-panel displays have been contemplated. Representative of earlier organic EL devices are US-A-3,172,862, US-A-3,173,050; and US-A-3,710,167. Typical organic emitting materials were formed of a conjugated organic host material and a conjugated organic activating agent having condensed benzene rings. The organic emitting material was present as a single layer medium having a thickness much above 1 micrometer. Thus, this organic EL medium was highly resistive and the EL device required an extremely high voltage (>100 volts) to operate.

The most recent discoveries in the art of organic EL device construction have resulted in devices having the organic EL medium consisting of extremely thin layers (<1.0 micrometer in combined thickness) separating the anode and cathode. The thin organic EL medium offers reduced resistance, permitting higher current densities for a given level of electrical bias voltage. In a basic two-layer EL device structure, one organic layer is specifically chosen to inject and transport holes and the other organic layer is specifically chosen to inject and transport electrons. The interface between the two layers provides an efficient site for the recombination of the injected hole-electron pair and resultant electroluminescence. Examples are provided by US-A-4,356,429; US-A-4,539,507; US-A-4,720,432; US-A-4,885,211; US-A-4,950,950; US-A-5,047,687; US-A-5,059,861; US-A-5,061,569; US-A-5,073,446; US-A-5,141,671; US-A-5,150,006; and US-A-5,151,629.

The simple structure can be modified to a three-layer structure, in which an additional luminescent layer is introduced between the hole and electron transporting layers to function primarily as the site for hole-electron recombination and thus electroluminescence. In this respect, the functions of the individual organic layers are distinct and can therefore be optimized independently. Thus, the luminescent or recombination ayer can be chosen to have a desirable EL color as well as a high luminance efficiency. Likewise, the electron and hole transport layers can be optimized primarily for the carrier transport property.

The organic EL devices can be view as a diode which is forward biased when the anode is at a higher potential than the cathode. The anode and cathode of the organic EL device can each take any convenient conventional form, such as any of the various forms disclosed by US-A-4,885,211. Operating voltage can be substantially reduced when using a low-work function cathode and a high-work function anode. The preferred cathodes are those constructed of a combination of a metal having a work function less than 4.0 eV and one other metal, preferably a metal havin a a work function greater than 4.0 eV. The Mg:Ag of US-A-4,885,211 constitute one preferred cathode construction. The Al:Mg cathodes of US-A-5,059,062 are another preferred cathode construction. The use of a LiF/Al bilayer to enhanced electron injection in organic EL devices has been disclosed in US-A-5,624,604.

Conventional ar odes are formed of a conductive and transparent oxide. Indium tin oxide has been widely used as the anode contact because of its transparency, good conductivity, and high work function. However, a device grown on a bare ITO surface generally shows insufficient hole injection and poor operational stability. The mitig ation of these problems has involved introducing an intermediate layer between the ITO and the organic medium. Yang et al reported a polymer EL device with improved charge carrier injection by using a polyaniline layer between the ITO and active luminescent layer. See " Enhanced performance of polymer light-emitting diode using high-surface area polyaniline network electrodes" by Y. Yang, E. Westerweele, C. Zhang, P. Smith, and A.J. Heeger, Journal of Applied Physics Letters, Vol. 77, 694 (1995). VanSlyke et al demonstrated a highly stable organic device formed by using a CuPc layer between the ITO and the hole transporting layer. See "Organic electroluminescent devices with improved stability" by S.A. VanSlyke, C.H. Chen, and C.W. Tang, Applied Physics Letters, Vol. 69, 2160 (1996). We also found that the ITO anode contact to an organic EL device can be significantly improved via oxygen plasma treatment without introducing a CuPc layer. The resulting device can be operated at low voltages, and exhibits good stability. The observation is consistent with the finding by Wu et al in polymer light-emitting diodes. See " Surface modification of indium tin oxide by plasma treatment: an effective method to improve the efficiency, brightness, and reliability of organic light emitting devices" by C.C. Wu, C.I. Wu, J.C. Sturm, and A. Kahn, Applied Physics Letters, Vol. 70, 1348 (1997). However, for application it is necessary to further enhance hole injection and improve operational stability.

It is an object of the present invention to provide a multilayer electrode which is particularly suitable for use in electroluminescent devices.

It is a further object to provide organic electroluminescent devices with efficient hole injection/transport and good operational stability.

These objects are achieved by an electroluminescent device comprising:
a) a substrate, said substrate formed of an electrically insulating material which can be either an optically transparent material or an opaque material;
b) a multilayer anode mounted on the substrate and having
   i) a conductive layer provided over the substrate and
   ii) a fluorocarbon layer grown on the conductive layer;
c) an organic medium for luminescence; and
d) a cathode formed over the organic medium.

Devices using electrodes made in accordance with the present invention exhibit superior current-voltage and luminescence-voltage characteristics and superior operational stability over a conventional EL device without a fluorocarbon layer.

These and other advantages of this invention can be better appreciated by reference to the following detailed description considered in conjunction with the drawings in which:
FIG. 1 is a schematic diagram of an embodiment of an electrode structure;
FIG. 2 is a schematic diagram of an organic electroluminescent device having a multilayer eletrode in accordance with the present invention;
FIG. 3 shows plots of current density vs. drive voltage for a series of devices as follows: A) with a prior art ITO anode, B) a prior art oxygen plasma-treated ITO anode, and C), D), and E) using electrodes made in accordance with the present invention;
FIG. 4 shows plots of electroluminescence output vs. drive voltage for: A) a device having an ITO anode, B) a device having an oxygen plasma-treated ITO anode, and C) a device having an anode in accordance with the present invention; and
FIG. 5A (for a prior art oxygen plasma-treated anode) and FIG. 5B (for an anode made in accorda ice with the present invention) respectively show plots of normalized luminescence vs. time and of drive voltage vs. time.

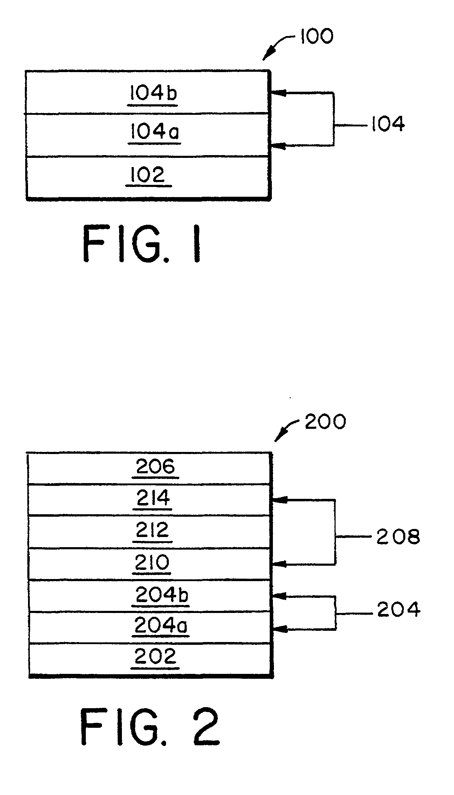

An electrode structure 100 is schematically illustrated in FIG. 1. The support layer 102 is an electrically insulating and optically transparent material such as glass or plastic. A bilayer 104 over the support layer 102 is formed of a conductive and transmissive layer 104a and a fluorocarbon overcoating layer 104b. The bilayer can be used as an anode for efficient hole injection in organic EL devices formed by polymer or small-molecule organic materials, as exemplified in FIG. 2.

In FIG. 2, an organic electroluminescent device 200 is illustrative which uses a multilayer electrode in accordance with the present invention. An insulating and transparent support is layer 202. An anode 204 is formed of a conductive and transmissive layer 204a and a fluorocarbon overcoating layer 204b. The anode 204 is separated from a cathode 206 by an electroluminescent medium 208, which includes three superimposed layers. Located on top of the anode layer 204 are, in sequence, an organic hole transporting layer 210, an organic luminescent layer 212, and an organic electron transporting layer 214. It is also understood that the electroluminescent medium can be a single layer or a bilayer comprising a hole transporting layer and an electron transporting layer. In such a configuration, the interface between the two layers provides an efficient site for the recombination of the injected hole-electron pair and resultant electroluminescence. It will also be understood that the electroluminescent medium can include more than three layers.

The substrate 102 for electrode structure 100 shown in FIG. 1 and the substrate 202 for organic electroluminescent device 200 shown in FIG. 2 are electrically insulated and can either be light transmissive or opaque. The light transmissive property is desirable for viewing the EL emission through the substrate. For applications where the EL emission is viewed through the top electrode, the transmissive characteristic of the support is immaterial, and therefore any appropriate substrate such as opaque semiconductor and ceramic wafers can be used. Of course, it is necessary to provide in these device configurations a light transparent top electrode.

The multilayer electrode 104 (see FIG. 1) and 204 (see FIG. 2), respectively, are formed of a conductive and transmissive layer 104a and 204a and a fluorocarbon overcoating layer 104b and 204b. The light transparent property of the layer 104a and 204a is desirable for viewing the EL emission through the substrate. For applications where the EL emission is viewed through the top electrode, the transmissive characteristic of the layer 104a and 204a is immaterial, and therefore any appropriate materials such as an opaque metal or metal compound having a work func ion greater than 4.1 eV can be used. The metals include gold, iridium, palladium, and platinum. The conductive and transmissive layer can be selected from the group of metal oxides, nitrides such as gallium nitride, selenides such as zinc selenide, and sulphides such as zinc sulphide. The suitable metal oxides include indium-tin oxide, aluminum- or indium-doped zinc oxide, tin oxide, magnesium-indium oxide, nickel-tungsten oxide, and cadmium-tin oxide.

After formation of the conductive layer, a layer mainly made of fluorocarbon 104b and 204b is formed on the conductive layer 104a and 204a, respectively. This fluorocarbon layer is an essential part in this invention. It has excellent durability for alkali or acid. It has a high work function, resulting in efficient hole injection and transport. It adheres well to the conductive layer and forms a buffer layer between the conductive layer and the hole transporting layer, thus significantly improving device operational stability.

The surface of the aforementioned conductive layer my be processed beforehand to improve its adhesion to the fluorocarbon overcoating layer. The types of processing include sputtering processing, corona processing, UV irradiation, or oxygen plasma treatment.

The thickness of the fluorocarbon is so selected that it would have a full coverage on the underlying conductive layer, and that its series resistance would not significantly affect device performance. A useful range of the thickness is from 1 to 200 nm, preferably 5-60 nm. This fluorocarbon layer can be deposited by many conventional means, s ich as spin-coating or dip-coating of Cyclized Perfluoro Polymer (CPFP), evaporation, and plasma polymerization using various gases containing carbon and fluorine such as decafluorobutane (C₄F₁₀) and tetrafluoroethylene (CHF₃).

The composition of the EL medium is described as follows, with reference to device structure 200.

The hole transporting layer of the organic EL device contains at least one hole transporting aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monarylamine, diarylamine, triarylamine, or a polymeric arylamine. Exemplary monomeric triarylamines are illustrated in US-A-3,180,730. Other suitable triarylamines substituted with vinyl or vinyl radicals and/or containing at least one active hydrogen containing group are disclosed in US-A-3,567,450 and US-A-3,658,520.

The luminescent layer of the organic EL device comprises of a luminescent or fluorescent material where electroluminescence is produced as a result of electron-hole pair recombination in this region. In the simplest construction, the luminescent layer comprises of a single component, that is a pure material with a high fluorescent efficiency. A well known material is tris (8-quinolinato) aluminum, (Alq), which produces excellent green electroluminescence. A preferred embodiment of the luminescent layer comprises a multi-component material consisting of a host material doped with one or more components of fluorescent dyes. Using this method, highly efficient EL devices can be constructed. Simultaneously, the color of the EL devices can be tuned by using fluorescent dyes of different emission wavelengths in a common host material.
This dopant scheme has been described in considerable details for EL devices using Alq as the host material in US-A-4,769,292.

Preferred materials for use in forming the electron transporting layer of the organic EL devices of this invention are metal chelated oxinoid compounds, including chelates of oxine itself (also commonly referred to as 8-quinolinol or 8-hydroxyquinoline). Such compounds exhibit both high levels of performance and are readily fabricated in the form of thin layers.

The organic EL devices of this invention can employ a cathode constructed of any metal having a work function lower than 4.0 eV, such as calcium and lithium. Unexpected fabrication, performance, and stability advantages have been realized by forming the cathode of a combination of a low work function metal and at least one other metal. For further disclosure, see U.S. Patent 4,885,211 by Tang and Van Slyke, the disclosure of which is incorporated by reference herein. A bilayer structure of LiF/Al has been used to enhance electron injection, as disclosed in US-A-5,624,604.

### Fluorocarbon Layer Preparation and Characterization

Fluorocarbon coating was carried out in a parallel plate RF reactor with CHF₃ at 500 mTorr and 100 W of power. A fluorocarbon layer with a thickness of about 20 nm was deposited on an indium-tin oxide coated glass substrate and analyzed with x- ray photoelectron spectroscopy (XPS). The peaks of CH, CF, CF₂, and CF₃ were observed for the polymerized fluorocarbon layer. The ionization potential of the fluorocarbon layer was determined by ultraviolet photoelectron spectroscopy (UPS) to be greater than 9.0 eV. Contact angle measurement was performed t y observing the wettability of a water droplet on the layer surface. The layer was highly hydrophobic with a contact angle greater than 95°.

### Examples

The invention and its advantages are further illustrated by the specific examples as follows:

### Example 1 (prior art)

An EL device was constructed in the following manner. The EL medium has three organic laye rs, namely, a CuPc layer, a hole transporting layer, and an electron transporting layer.
a) An indi im-tin-oxide (ITO) coated glass substrate was sequentially ultrasonicated in a commercial detergent, rinsed in deionized water, degreased in toluene vapor and exposed to oxygen plasma for a few minutes.
b) A hole injecting layer of copper phthalocyanine (150 Angstroms) was then deposited on top of the ITO coated substrate by evaporation from a tantalum boat.
c) Onto the copper phthalocyanine layer was deposited a hole transporting layer of N,N'-bis-(1-naphthyl)-N,N'-diphenylbenzidine (600 Angstroms), also by evaporation from a tantalum boat
d) An electron transporting layer of Alq (600 Angstroms) was then deposited onto the hole transporting layer by evaporation from a tantalum boat.
f) On top of the Alq layer was deposited by evaporation a cathode layer (2000 Angstroms) formed of a 10:1 atomic ratio of Mg and Ag.

The above sequence completed the deposition of the EL device. The device was then hermetically packaged in a dry glove box for protection against ambient environment.

The drive voltage was 12 V at a current density of 100 mA/cm². The luminescence output from this EL device was 0.45 mW/cm² when it was operated at 9 V. The device was then operated at 40 mA/cm² constant current with a 50% duty cycle, and both forward drive voltage and luminescence were measured. It was found that the drive voltage increased by one volt after operation for 2,000 hours. The luminescence progressively decreased and reached one half of its initial value after 2,000 hours.

### Example 2 (prior art)

An EL device was constructed in the following manner. The EL medium has two organic layers, namely, a hole transporting layer and an electron transporting layer.
a) An indium-tin-oxide (ITO) coated glass substrate was sequentially ultrasonicated in a commercial detergent, rinsed in deionized water, degreased in toluene vapor, and spin-dried
b) Onto the indium-tin oxide layer was deposited a hole transporting layer of N,N'-bis-(1-naphthyl)-N,N'-diphenylbenzidine (750 Angstroms), also by evaporation from a tantalum boat.
c) An elec tron transporting layer of Alq (600 Angstroms) was then deposited onto the hole transporting layer by evaporation from a tantalum boat.
d) On top of the electron transporting layer was deposited by evaporation a cathode layer (2000 Angstroms) formed of a 10:1 atomic ratio of Mg and Ag.

The above sequence completed the deposition of the EL device. The device was then hermetically packaged in a dry glove box for protection against ambient environment.

The drive voltage was 12.3 V at a current density of 100 mA/cm². The luminescence output from this EL device was 0.40 mW/cm² when it was operated at 9 V. Stability tests at 40 mA/cm² constant current with a 50% duty cycle showed a rapid increase of applied voltages, indicating poor operational stability.

### Example 3 (prior art)

An EL device was constructed in the following manner. The EL medium has two organic layers namely, a hole transporting layer and an electron transporting layer.
a) An indium-tin-oxide (ITO) coated glass substrate was sequentially ultrasonicated in a commercial detergent, rinsed in deionized water, degreased in toluene vapor and exposed to oxygen plasma for a few minutes.
b) Onto the indium tin oxide layer was deposited a hole transporting layer of N,N'-bis-(1-naphthyl)-N,N'-diphenylbenzidine (600 Angstroms), also by evaporation from a tantalum boat
c) An elect on transporting layer of Alq (600 Angstroms) was then deposited onto the hole transporting layer by evaporation from a tantalum boat.
d) On top of the electron transporting layer was deposited by evaporation a cathode layer (2000 Angstroms) formed of a 10:1 atomic ratio of Mg and Ag.

The above sequence completed the deposition of the EL device. The device was then hermetically packaged in a dry glove box for protection against ambient environment.

The drive voltage was 11 V at a current density of 100 mA/cm². The luminescence output from this EL device was 1.36 mW/cm² when it was operated at 9 V. The operational stability of the device was found to be comparable with that disclosed in Example 1.

### Example 4

An EL device satisfying the requirements of the invention was constructed in the following manner. The medium has two organic layers, namely, a hole transporting layer and an electron transporting layer.
a) An indium-tin-oxide (ITO) coated glass substrate was sequentially ultrasonicated in a commercial detergent, rinsed in deionized water, degreased in toluene vapor and exposed to oxygen plasma for a few minutes.
b) A fluorocarbon layer (100 Angstroms) was then deposited on top of the ITO coated substrate by plasma polymerization in the RF reactor.
c) Onto the fluorocarbon layer was deposited a hole transporting layer of N,N'-bis-(1-naphthyl)-N,N'-diphenylbenzidine (600 Angstroms), also by evaporation from a tantalum boat.
d) An electron transporting layer of Alq (600 Angstroms) was then deposited onto the hole transporting layer by evaporation from a tantalum boat.
e) On top of the electron transporting layer was deposited by evaporation a cathode layer (2000 Angstroms) formed of a 10:1 atomic ratio of Mg and Ag.

The above sequence completed the deposition of the EL device. The device was then hermetically packaged in a dry glove box for protection against ambient environment.

The drive volta ge was 8.0 V at a current density of 100 mA/cm². The luminescence output from this EL device was 4.5 mW/cm² when it was operated at 9 V. The device is extremely stable with a luminescence loss of less than 3% of its initial value after operation for 350 hours.

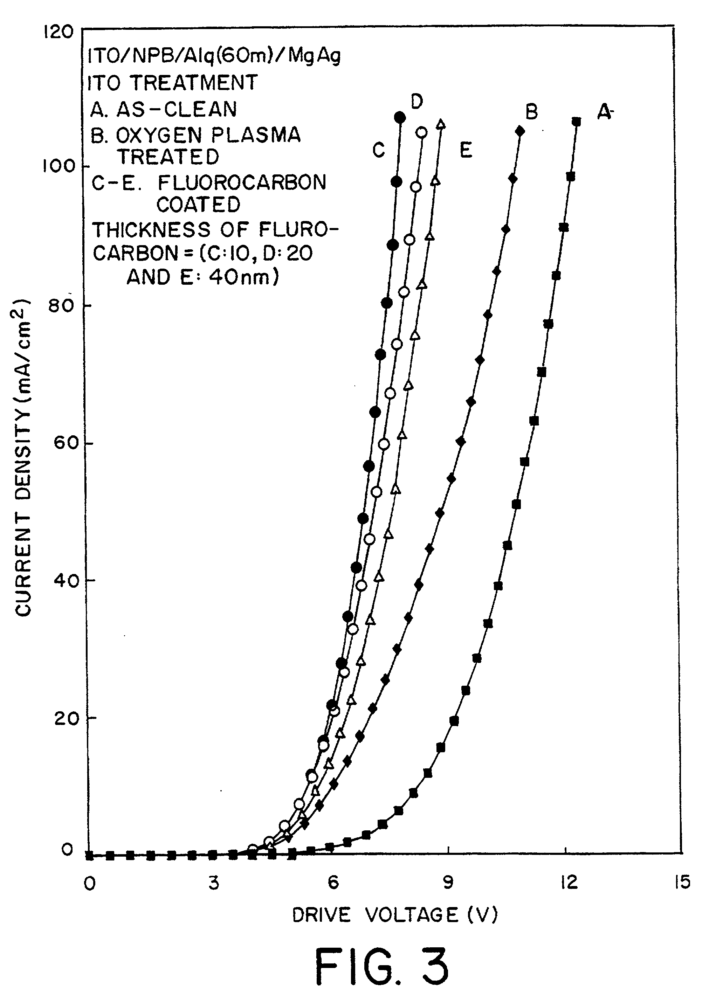

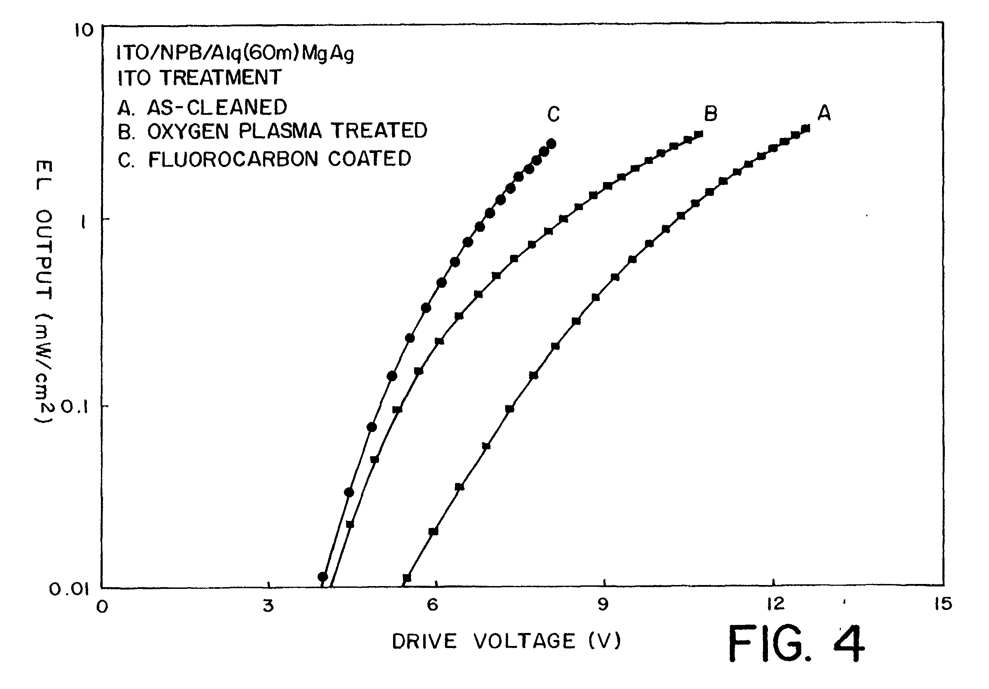

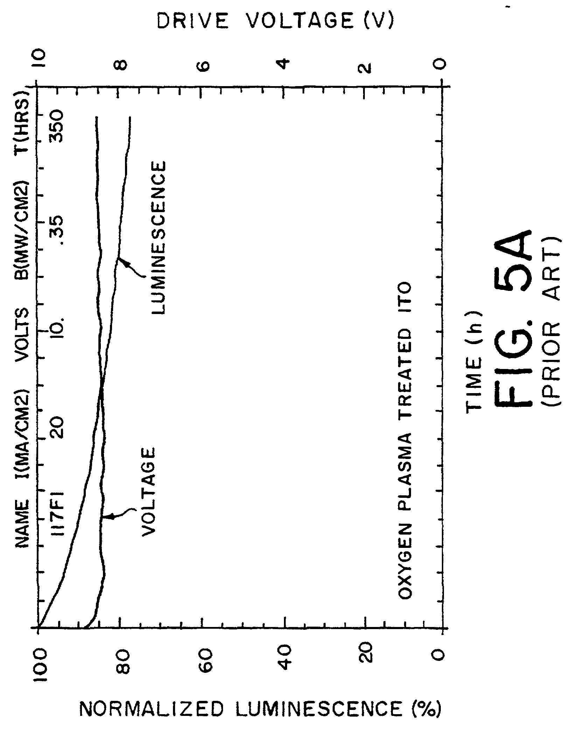

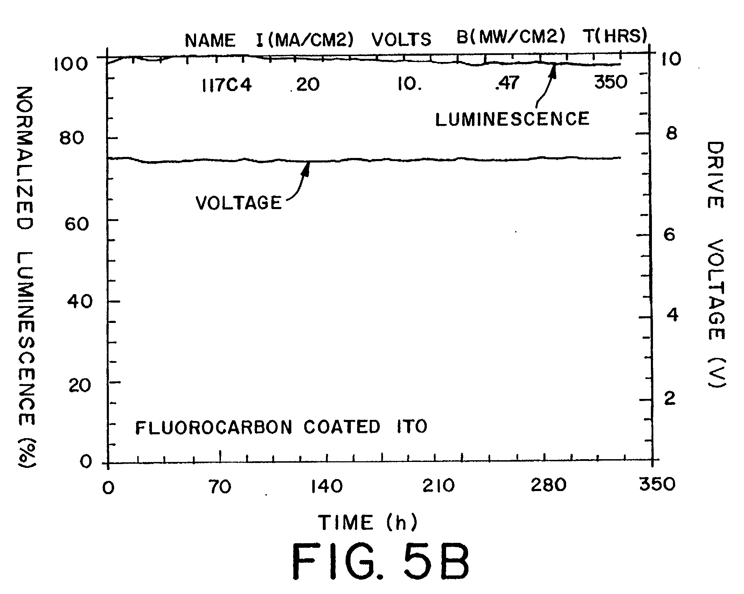

FIG. 3. shows current density vs. drive voltage characteristics of the devices described in Examples 2, 3, and 4. FIG. 4 shows luminescence output of the three devices as a function of applied voltage. The results clearly indicate that an inventive device with a fluorocarbon-coated ITO anode can be operated at lower voltages and exhibits higher EL output at a fixed voltage, as compared to the prior art devices disclosed in Examples 1-3. This result was unexpected. FIG. 5 shows plots of operational stab ility for the devices shown in Examples 3 (prior art) and 4 (present invention). The drive voltage was found to remain constant in the both cases. The electroluminescence output from the device with an oxygen plasma-treated ITO anode decreased to approximately 75% of its initial value, while the loss of luminescence in the device with a fluorocarbon-coated ITO anode was about 3%.

### Example 5

Two EL device satisfying the requirements of the invention was constructed in the following manner. The medium has two organic layers, namely, a hole transporting layer and ar electron transporting layer.
a) An indium-tin-oxide (ITO) coated glass substrate was sequentially ultrasonicated in a commercial detergent, rinsed in deionized water, degreased in toluene vapor and exposed to oxygen plasma for a few minutes.
b) A fluorocarbon layer (200 and 400 Angstroms, respectively) was then deposited on top of the ITO coated substrate by plasma polymerization in the RF reactor.
c) Onto the fluorocarbon layer was deposited a hole transporting layer of N,N'-bis-(1-naphthyl)-N,N'-diphenylbenzidine (600 Angstroms), also by evaporation from a tantalum boat.
d) An electron transporting layer of Alq (600 Angstroms) was then deposited onto the hole transporting layer by evaporation from a tantalum boat.
e) On top of the electron transporting layer was deposited by evaporation a cathode layer (2000 Angstroms) formed of a 10:1 atomic ratio of Mg and Ag.

The above sequence completed the deposition of the EL device. The device was then hermetically packaged in a dry glove box for protection against ambient environment.

The resulting devices are similar to that disclosed in Example 4.

Other features of the invention are included below:

The device wherein the organic medium includes an organic luminescent layer.

The device wherein the organic medium includes an organic hole transporting layer and an organic electron transporting layer.

The device wherein the organic medium includes an organic hole transporting layer, an organic luminescent layer, and an organic electron transporting layer.

The device wherein the organic medium includes polymer materials and small-molecule organic materials.

### PARTS LIST

- 100: electrode structure
- 102: substrate
- 104: electrode
- 104a: conductive layer
- 200: organic electroluminescent device
- 200: organic electroluminescent device
- 204b: fluorocarbon layer
- 202: substrate
- 204: anode
- 204a: conductive layer
- 204b: fluorocarbon layer
- 206: cathode
- 208: organic medium
- 210: organic hole transporting layer
- 212: organic luminescent layer
- 214: organic electron transporting layer

## Claims

1. An electroluminescent device (200)comprising:
a) a substrate (202), said substrate formed of an electrically insulating material which can be either an optically transparent material or an opaque material;
b) an anode (204) mounted on the substrate and having:
i) a conductive layer (204a) provided over the substrate; and
ii) a fluorocarbon layer (204b) grown on the conductive layer;
c) an organic medium (208) for luminescence; and
d) a cathode (206) formed over the organic medium.

2. The electroluminescent device of claim 1 wherein when the substrate is optically transparent, it is formed from glass or plastic.

3. The electroluminescent device of claim 1 wherein when the substrate is opaque, it is formed from a ceramic or semiconducting material.

4. The electroluminescent device of claim 1 wherein the conductive layer is transmissive and selected from the group consisting of a metal oxide, gallium nitride, zinc selenide, and zinc sulphide.

5. The electroluminescent device of claim 1 wherein the conductive layer is opaque and selected from the group consisting of a metal and a metallic compound having a work function greater than 4.1 eV.

6. The electroluminescent device of claim 4 wherein the metal oxide includes indium-tin oxide, aluminum- or indium-doped zinc oxide, tin oxide, magnesium-indium oxide, nickel-tungsten oxide, or cadmium-tin oxide.

7. The electroluminescent device of claim 5 wherein the metal includes gold, iridium, palladium, and platinum.

8. The electroluminescent device of claim 1 wherein the thickness of the fluorocarbon layer is in the range of 0.5 to 200 nm.

9. The electroluminescent device of claim 8 wherein the thickness of the fluorocarbon layer is in the range of 5 to 60 nm.

## Patentansprüche

1. Elektrolumineszente Vorrichtung (200) mit
a) einem Substrat (202), das aus einem elektrisch isolierenden Material besteht, welches entweder ein optisch transparentes oder lichtundurchlässiges Material sein kann;
b) einer Anode (204), die auf dem Substrat angeordnet ist und folgende Komponenten aufweist:
i) eine über dem Substrat vorgesehene, leitfähige Schicht (204a); und
ii) eine auf der leitfähigen Schicht gezüchtete Fluorkohlenstoff-Schicht (204b);
c) einem organischen Medium (208) für die Lumineszenz; und
d) einer über dem organischen Medium gebildeten Kathode (206).

2. Elektrolumineszente Vorrichtung nach Anspruch 1, **dadurch gekennzeichnet, dass** sie bei optisch transparentem Substrat aus Glas oder Kunststoff besteht.

3. Elektrolumineszente Vorrichtung nach Anspruch 1, **dadurch gekennzeichnet, dass** sie bei lichtundurchlässigem Substrat aus einem Keramikmaterial oder Halbleitermaterial besteht.

4. Elektrolumineszente Vorrichtung nach Anspruch 1, **dadurch gekennzeichnet, dass** die leitfähige Schicht durchlässig ist und aus der Gruppe ausgewählt ist, die aus einem Metalloxid, aus Galliumnitrid, Zinkselenid und Zinksulfid besteht.

5. Elektrolumineszente Vorrichtung nach Anspruch 1, **dadurch gekennzeichnet, dass** die leitfähige Schicht lichtundurchlässig ist und aus der Gruppe ausgewählt ist, die aus einem Metall und einer Metallverbindung mit einer 4,1 eV übersteigenden Austrittsarbei besteht.

6. Elektrolumineszente Vorrichtung nach Anspruch 4, **dadurch gekennzeichnet, dass** das Metalloxid Indium-Zinn-Oxid, Aluminium- oder indiumdotiertes Zinkoxid, Zinnoxid, Magnesium-Indium-Oxid, Nickel-Wolfram-Oxid oder Cadmium-Zinn-Oxid umfasst.

7. Elektrolumineszente Vorrichtung nach Anspruch 5, **dadurch gekennzeichnet, dass** das Metall Gold, Iridium, Palladium und Platin umfasst.

8. Elektrolumineszente Vorrichtung nach Anspruch 1, **dadurch gekennzeichnet, dass** die Dicke der Fluorkohlenstoff-Schicht im Bereich zwischen 0,5 und 200 nm liegt.

9. Elektrolumineszente Vorrichtung nach Anspruch 8, **dadurch gekennzeichnet, dass** die Dicke der Fluorkohlenstoff-Schicht im Bereich zwischen 5 und 60 nm liegt.

## Revendications

1. Dispositif électroluminescent (200) comprenant :
a) un substrat (202), ledit substrat étant formé d'un matériau électriquement isolant qui peut être soit un matériau optiquement transparent soit un matériau opaque,
b) une anode (204) montée sur le substrat et comportant :
i) une couche conductrice (240a) disposée sur le substrat, et
ii) une couche de fluorocarbone (204b) mise à croître sur la couche conductrice,
c) un milieu organique (208) destiné à la luminescence, et
d) une cathode (206) formée sur le milieu organique.

2. Dispositif électroluminescent selon la revendication 1 dans lequel lorsque le substrat est optiquement transparent, il est formé à partir de verre ou de matière plastique.

3. Dispositif électroluminescent selon la revendication 1 dans lequel lorsque le substrat est opaque, il est formé à partir d'une céramique ou d'un matériau semiconducteur.

4. Dispositif électroluminescent selon la revendication 1 dans lequel la couche conductrice est du type à transmission et est sélectionnée à partir du groupe constitué d'un oxyde métallique, de nitrure de gallium, de séléniure de zinc et de sulfure de zinc.

5. Dispositif électroluminescent selon la revendication 1 dans lequel la couche conductrice est opaque et est sélectionnée à partir du groupe constitué d'un métal et d'un composé métallique présentant un travail de sortie supérieur à 4,1 eV.

6. Dispositif électroluminescent selon la revendication 4 dans lequel l'oxyde métallique comprend de l'oxyde d'étain-indium, de l'oxyde de zinc dopé à l'aluminium ou à l'indium, de l'oxyde d'étain, de l'oxyde de magnésium-indium, de l'oxyde de nickel-tungsten, ou de l'oxyde de cadmium-étain.

7. Dispositif électroluminescent selon la revendication 5 dans lequel le métal comprend de l'or, de l'iridium, du palladium, et du platine.

8. Dispositif électroluminescent selon la revendication 1 dans lequel l'épaisseur de la couche de fluorocarbone se trouve dans la plage de 0,5 à 200 nm.

9. Dispositif électroluminescent selon la revendication 8 dans lequel l'épaisseur de la couche de fluorocarbone se trouve dans la plage de 5 à 60 nm.
